# FASCICULE DE BREVET EUROPEEN

(11) **EP 0 468 897 B1**
(45) Date de publication et mention de la délivrance du brevet: **15.11.1995**
(21) Numéro de dépôt: 91420256.9
(22) Date de dépôt: 16.07.1991
(51) Int. Cl.: H01J 37/32, G01B 11/06, H01L 21/321, H01L 21/66, H01L 21/768

(54) **Procédé de détermination de l'élimination complète d'une couche mince sur un substrat non plan**
Verfahren zur Bestimmung der vollständigen Abtragung einer Dünnschicht auf einem nichtplanaren Substrat
Process for the determination of the complete removal of a thin film on a non-planar substrate

(30) Priorité: 20.07.1990 FR 9009467
(43) Date de publication de la demande: 29.01.1992
(73) Titulaire: FRANCE TELECOM, 75015 Paris (FR)
(72) Inventeur: Galvier, Jean, F-38400 Saint Martin D'Heres (FR); Gayet, Philippe, F-38660 Saint Vincent de Mercuze (FR); Tissier, Annie, F-38330 Saint Ismier (FR)
(74) Mandataire: de Beaumont, Michel

(56) Documents cités:
- EP-A- 0 294 873
- US-A- 4 141 780
- US-A- 4 840 487
- THIN SOLID FILMS, vol. 109, no. 4, 25 novembre 1983, pages 363-369; E.S. BRAGA et al.: "Optical monitoring of the end point in thin plasma etching"
- PROCEEDINGS OF THE SPIE, vol. 990, CHEMICAL, BIOCHEMICAL AND ENVIRONMENTAL APPLICATON OF FIBERS, 1988, pages 158-162; B. LALOUX et al.: Non-destructive testing of reflow on Si wafer"

## Description

La présente invention concerne un procédé permettant de détecter la fin d'attaque, et plus particulièrement l'élimination complète, d'une couche mince déposée sur un substrat. L'invention trouve des applications dans le domaine de la fabrication des circuits intégrés, en particulier afin de détecter la fin de l'attaque d'une couche mince métallique déposée sur un substrat présentant un certain relief.

Dans un certain nombre d'opérations entrant dans la fabrication des circuits intégrés, on est amené à graver une couche métallique déposée sur une couche en matériau isolant. Il en est ainsi, par exemple, lors de la réalisation de plusieurs niveaux d'interconnexion, au cours de laquelle on procède classiquement à la gravure de parties d'une couche métallique déposée sur une couche d'oxyde de silicium qui épouse les structures sous-jacentes et qui présente en conséquence un certain relief. On souhaite, dans ce cas, poursuivre une opération de gravure jusqu'à obtenir l'enlèvement complet de cette couche métallique dans certaines zones. Il faut cependant arrêter cette opération de gravure rapidement après cet enlèvement complet de la couche métallique, parce que la poursuite de cette gravure pourrait modifier ou altérer d'autres structures et en outre allongerait inutilement la durée de fabrication.

Une difficulté réside dans le fait que, dans la phase finale de l'opération de gravure, la couche métallique ne subsiste que sous forme de résidus du métal de très faibles dimensions. Habituellement, ces résidus sont situés au voisinage des marches présentes dans la couche isolante sous-jacente. Etant donné que ces résidus ont de faibles dimensions, ils ne sont pas détectables par les systèmes classiques de détection de fin d'attaque. Pour être certain qu'aucun résidu ne subsistera après cette opération de gravure, on est donc amené classiquement à prolonger la durée de gravure de la couche métallique.

Un objet de la présente invention est de prévoir un procédé de détermination précise de l'élimination complète d'une couche mince déposée sur un substrat.

Un autre objet de la présente invention est de prévoir un tel procédé qui puisse être utilisé comme moyen de contrôle pour vérifier qu'une opération de gravure a été menée de façon satisfaisante.

Un autre objet de la présente invention est de prévoir un tel procédé qui puisse être mis en oeuvre in situ pendant une opération de gravure.

Pour atteindre ces objets, l'invention prévoit un procédé de détermination de l'élimination complète d'une couche mince déposée sur un substrat, comprenant les étapes consistant à prévoir sur une zone de substrat un réseau de diffraction optique, la couche mince déposée sur le substrat recouvrant aussi ce réseau de diffraction, et l'attaque de la couche mince s'effectuant aussi au niveau de ce réseau de diffraction; éclairer le réseau par un faisceau lumineux monochromatique; et observer l'évolution de la lumière diffractée au cours de l'opération d'attaque de la couche mince, afin de déterminer l'instant où le matériau de la couche mince est intégralement ôté.

Selon un mode de réalisation de la présente invention, le substrat correspond à une couche d'oxyde de silicium, le réseau de diffraction est obtenu par gravure anisotrope d'une zone déterminée de cette couche, et la couche mince est métallique.

Selon un mode de réalisation de la présente invention, la figure de diffraction obtenue à partir du réseau est comparée à des figures de diffraction obtenues lors d'un étalonnage.

Ces objets, caractéristiques et avantages ainsi que d'autres de la présente invention seront illustrés plus en détail dans la description suivante de modes de réalisation particuliers faite en relation avec les figures jointes parmi lesquelles :
la figure 1A représente schématiquement, en coupe transversale, une structure résultant de la mise en oeuvre du procédé selon l'invention, telle qu'elle apparaît lors d'une phase initiale de l'opération de gravure ;
la figure 1B représente une figure de diffraction correspondant à la structure de la figure 1A ;
les figures 2A et 2B correspondent respectivement aux figures 1A et 1B lors d'une phase intermédiaire de l'opération de gravure ; et
les figures 3A et 3B correspondent respectivement aux figures 1A et 1B lors de la phase finale de gravure.

Le procédé selon l'invention va être décrit dans le cas particulier de la gravure du deuxième niveau d'interconnexion d'un circuit intégré à plusieurs niveaux d'interconnexion. Il est toutefois clair que cela ne constitue qu'un exemple et que l'invention s'applique de façon générale à la détermination de l'élimination complète d'une couche mince.

Pour réaliser plusieurs niveaux d'interconnexion, on dépose une première couche métallique qui est gravée selon un motif de connexion choisi, puis une couche isolante, souvent en oxyde de silicium, dans laquelle on ménage des trous de passage. On dépose par dessus la couche isolante une seconde couche métallique qui vient remplir les trous de passage. On effectue ensuite une gravure pleine plaque de cette seconde couche métallique afin d'enlever complètement le métal de cette couche présent sur la couche isolante sous-jacente, et en ne conservant du métal qu'à l'intérieur des trous de passage ménagés dans la couche isolante. Enfin on dépose une troisième couche métallique qui est gravée selon un motif de connexion choisi. L'opération de gravure de la seconde couche métallique est particulièrement délicate. En effet, cette gravure doit être prolongée assez longtemps pour qu'il n'y ait plus aucun résidu métallique sur la couche isolante, mais cette opération de gravure ne doit pas être prolongée au-delà pour éviter d'enlever trop de métal présent dans les trous de passage.

Comme cela est illustré en figure 1A, selon l'invention, dans le cas de la gravure de la seconde couche métallique, on dépose dans une zone inutilisée d'une plaquette en cours de traitement de couche isolante 1 constituant une partie de la couche isolante susmentionnée. On forme dans cette zone un réseau de diffraction optique constitué d'un certain nombre de nervures équidistantes 2, 2′. La hauteur des nervures est du même ordre de grandeur que la hauteur des marches présentes sur le reste de la plaquette au niveau des circuits en cours de réalisation. La seconde couche métallique 3 recouvrant la couche isolante 1 recouvre également la zone comprenant le réseau de diffraction 2, 2′ et épouse le relief des nervures. La gravure de cette couche métallique 3 s'effectue dans la zone comprenant le réseau de diffraction en même temps que dans la zone utile.

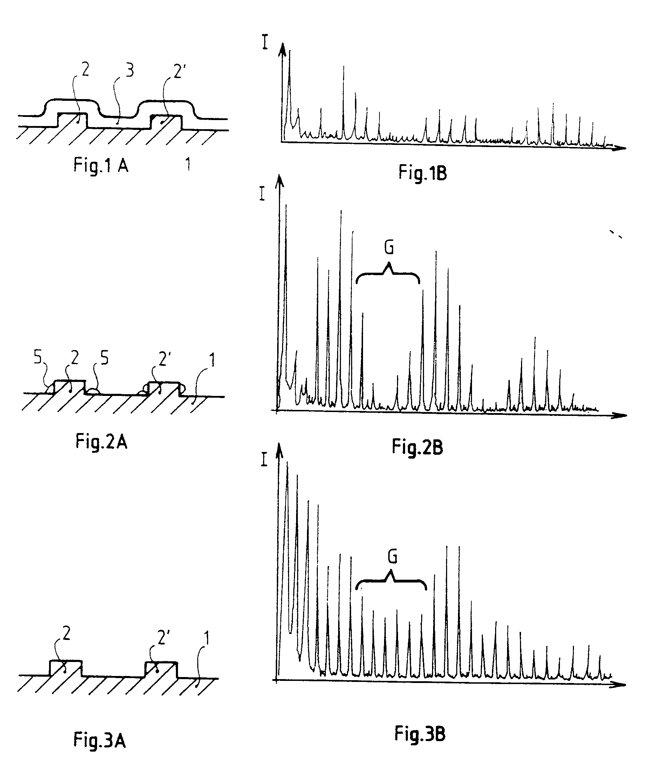

La figure 2A représente la même structure lorsque l'opération de gravure de la couche métallique 3 est presque achevée. Des résidus 5 du métal de la couche 3 subsistent, ces résidus se localisant principalement au pied des flancs verticaux du réseau de diffraction ou à leur voisinage. Ces résidus 5 peuvent présenter des formes diverses et ont des dimensions extrêmement faibles. Tant que subsistent de tels résidus 5, il convient de poursuivre l'opération de gravure, jusqu'à leur enlèvement complet, comme cela a été expliqué précédemment.

La figure 3A représente la structure lorsque les résidus ont complètement disparu.

Selon un mode de mise en oeuvre de la présente invention, pendant l'opération de gravure de la couche 3, on éclaire le réseau de diffraction par un faisceau lumineux monochromatique et on observe l'évolution de la lumière diffractée.

Les figures 1B, 2B et 3B représentent des figures de diffraction correspondant aux structures respectivement représentées en figures 1A, 2A et 3A. On observe une série de spots lumineux intenses de part et d'autre de la tache de réflexion spéculaire (un seul côté de la figure de diffraction est représenté sur les figures 1B à 3B et seulement à partir de l'ordre 6).

Les demandeurs ont remarqué que la figure de diffraction se modifie continûment au début de l'opération de gravure de la couche métallique 3. Cette figure de diffraction se modifie ensuite de façon très sensible lorsque l'on passe d'une couche 3 continue à des résidus épars et ensuite lorsque l'on passe du niveau de gravure correspondant à la figure 2A à celui correspondant à la figure 3A, c'est-à-dire lorsque l'on passe d'une structure dans laquelle subsistent des résidus de métal de très faibles dimensions, à une structure exempte de résidus métalliques. L'invention permet donc de détecter de façon très sensible la présence ou l'absence de résidus métalliques de très faibles dimensions, et cela d'une façon quasi-instantanée, pendant le déroulement de l'opération de gravure.

Pour exploiter, de façon automatique, les modifications de la figure de diffraction, on peut étudier l'ensemble du spectre ou sélectionner dans cette figure de diffraction une seule tache ou un certain groupe G de taches de diffraction. L'intensité lumineuse de cette tache ou de ce groupe de taches varie dans de grandes proportions lorsque l'on passe d'une phase de gravure au cours de laquelle subsistent des résidus métalliques 5 à une phase finale de gravure pour laquelle les résidus métalliques ont été complètement éliminés. On peut alors aisément mesurer de façon automatique l'intensité lumineuse de ce groupe de taches afin de déterminer l'instant où les résidus métalliques 5 sont intégralement ôtés, cet instant étant défini par le passage par un seuil prédéterminé de la valeur de cette intensité lumineuse.

On peut effectuer la mesure d'intensité lumineuse d'une ou de plusieurs taches à l'aide d'un analyseur se déplaçant le long de la figure de diffraction. On peut aussi effectuer la mesure par échantillonnage au moyen d'une barrette à diodes.

Le faisceau limineux est par exemple obtenu à l'aide d'un laser de type hélium/néon fonctionnant à une longueur d'onde de 632,8 nm.

L'homme de l'art notera que, bien que l'invention ait été décrite en relation avec une application particulière, elle s'applique de façon générale à la détection de l'élimination complète d'une couche mince déposée sur un substrat massif ou sur une autre couche mince.

D'autre part, on a décrit ci-dessous une mise en oeuvre in situ du procédé selon la présente invention dans laquelle le motif à tester est éclairé dans l'enceinte de gravure. La présente invention peut aussi être utilisée pour le contrôle de plaques gravées. En ce cas, on comparera la figure de diffraction obtenue en éclairant un motif de nervures 2 ayant subi une gravure à des figures de diffraction obtenues antérieurement au cours de phases d'étalonnage. Ce procédé de contrôle présente l'avantage d'être précis, non destructif et non polluant. Ainsi si l'on détecte qu'un lot de plaquettes a subi une gravure insuffisante, on pourra, sans inconvénient, le soumettre à une phase de gravure supplémentaire.

Alors que l'on a décrit précedemment un réseau de diffraction formé spécialement dans une zone inutilisée du substrat, on pourrait utiliser un motif utile formé dans une partie du circuit en cours de fabrication, par exemple une zone de mémoire.

## Revendications

1. Procédé de détermination de l'élimination complète d'une couche mince (3) déposée sur un substrat (1), caractérisé en ce qu'il comprend les étapes suivantes :
- prévoir sur une zone du substrat (1) un réseau de diffraction optique (2, 2′), la couche mince déposée sur le substrat recouvrant aussi ce réseau de diffraction, et l'attaque de la couche mince (3) s'effectuant aussi au niveau de ce réseau de diffraction ;
- éclairer le réseau (2, 2′) par un faisceau lumineux monochromatique ; et
- observer l'évolution de la lumière diffractée au cours de l'opération d'attaque de la couche mince (3), afin de déterminer l'instant où le matériau de la couche mince est intégralement ôté.

2. Procédé selon la revendication 1, caractérisé en ce qu'il comprend les étapes consistant à sélectionner dans la figure de diffraction un groupe (G) de taches de diffraction et à mesurer l'intensité lumineuse de ce groupe de taches, l'instant où le matériau de la couche mince est intégralement ôté étant défini par le passage par un seuil prédéterminé de la valeur de cette intensité lumineuse.

3. Procédé selon la revendication 1, caractérisé en ce que le substrat correspond à une couche d'oxyde de silicium et en ce que le réseau de diffraction est obtenu par gravure anisotrope d'une zone déterminée de cette couche.

4. Procédé selon la revendication 1, caractérisé en ce que la couche mince est métallique.

5. Procédé selon la revendication 1, caractérisé en ce que la figure de diffraction obtenue à partir dudit réseau est comparée à des figures de diffraction obtenues lors d'un étalonnage.

6. Procédé selon la revendication 1, caractérisé en ce que le réseau de diffraction est constitué par une partie d'un circuit intégré en cours de réalisation sur ledit substrat.

## Patentansprüche

1. Verfahren zum Bestimmen der vollständigen Eliminierung einer dünnen Schicht (3), die auf einem Substrat (1) abgeschieden bzw. deponiert ist, dadurch **gekennzeichnet,** daß es folgende Schritte alfweist:
- Vorsehen auf einem Gebiet des Substrats (1) eines optischen Beugungsgitters (2, 2′), wobei die dünne Schicht, die auf dem Substrat abgeschieden ist, ebenfalls das Beugungsgitter abdeckt, und wobei das Ätzen der dünnen Schicht (3) ebenfalls in dem Gebiet des Beugungsgitters ausgeführt wird;
- Beleuchten des Gitters (2, 2′) mit einem monochromtischen Lichtstrahl; und
- Beobachten der Entwicklung bzw. Evolution des gebeugten Lichts während des Ätzens der dünnen Schicht (3), um den Moment zu bestimmen, wenn das Material der dünnen Schicht vollständig entfernt ist.

2. Verfahren nach Anspruch 1, dadurch gekennzeichnet, daß es ferner folgende Schritte aufweist: Auswählen in dem Beugungsmuster einer Gruppe (G) von Beugungsflecken und Messen der Lichtintensität dieser Gruppe von Flecken, des Moments, wenn das Material der dünnen Schicht vollständig entfernt ist, und zwar definiert durch die Tatsache, daß der Wert dieser Lichtintensität eine vorbestimmte Schwelle erreicht.

3. Verfahren nach Anspruch 1, dadurch gekennzeichnet, daß das Substrat einer Siliciumoxidschicht entspricht und das Beugungsgitter enthalten wird durch anisotropes Ätzen eines vorbestimmten Gebiets der Siliciumoxidschicht.

4. Verfahren nach Anspruch 1, dadurch gekennzeichnet, daß die dünne Schicht metallisch ist.

5. Verfahren nach Anspruch 1, dadurch gekennzeichnet, daß das Beugungsmuster, das von dem Gitter erhalten wird mit Beugungsmustern verglichen wird, die während einer Kalibrierung erhalten wurden.

6. Verfahren nach Anspruch 1, dadurch gekennzeichnet, daß das Beugungsgitter aus einem Teil einer integrierten Schaltung hergestellt ist, die auf dem Substrat realisiert ist.

## Claims

1. A method for determining the complete elimination of a thin layer (3) deposited on a substrate (1), characterized in that it comprises the steps of:
- providing on an area of the substrate (1) an optical diffraction grating (2, 2′), the thin layer deposited on the substrate also covering said diffraction grating, and the etching of the thin layer (3) being also carried out in the area of the diffraction grating;
- illuminating the grating (2, 2′) with a monochromatic light beam; and
- observing the evolution of the diffracted light during the etching of the thin layer (3), in order to determine the moment when the material of the thin layer is entirely removed.

2. A method according to claim 1, characterized in that it comprises the steps of selecting in the diffraction pattern a group (G) of diffraction spots and measuring the light intensity of this group of spots, the moment when the material of the thin layer is entirely removed being defined by the fact that the value of this light intensity reaches a predetermined threshold.

3. A method as claimed in claim 1, characterized in that the substrate corresponds to a silicon oxide layer and the diffraction grating is obtained by anisotropic etching of a determined area of said silicon oxide layer.

4. A method as claimed in claim 1, characterized in that the thin layer is metallic.

5. A method as claimed in claim 1, characterized in that the diffraction pattern obtained from said grating is compared with diffraction patterns obtained during a calibration.

6. A method as claimed in claim 1, characterized in that the diffraction grating is made of a portion of an integrated circuit being realized on said substrate.
